**Europäisches Patentamt**

**European Patent Office**

**Office européen des brevets**

(11) Numéro de publication : **0 406 053 B1**

(12) # FASCICULE DE BREVET EUROPEEN

(45) Date de publication du fascicule du brevet :
**20.09.95 Bulletin 95/38**

(51) Int. Cl.$^6$ : **H01L 37/02**

(21) Numéro de dépôt : **90401672.2**

(22) Date de dépôt : **15.06.90**

(54) **Détecteur infrarouge à base de matériau pyroélectrique.**

(30) Priorité : **30.06.89 FR 8908799**

(43) Date de publication de la demande :
**02.01.91 Bulletin 91/01**

(45) Mention de la délivrance du brevet :
**20.09.95 Bulletin 95/38**

(84) Etats contractants désignés :
**DE FR GB NL**

(56) Documents cités :
**US-A- 4 755 707**
**PATENT ABSTRACTS OF JAPAN vol. 12, no.**
**228 (E-627)(3075) 28 juin 1988, & JP-A-63 20868**

(73) Titulaire : **THOMSON-CSF**
**173, Boulevard Haussmann**
**F-75008 Paris (FR)**

(72) Inventeur : **Robin, Philippe**
**THOMSON-CSF,**
**SCPI,**
**Cédex 67**
**F-92045 Paris la Défense (FR)**
Inventeur : **Broussoux, Dominique**
**THOMSON-CSF,**
**SCPI,**
**Cédex 67**
**F-92045 Paris la Défense (FR)**
Inventeur : **Dubois, Jean-Claude**
**THOMSON-CSF,**
**SCPI,**
**Cédex 67**
**F-92045 Paris la Défense (FR)**

(74) Mandataire : **Guérin, Michel et al**
**THOMSON-CSF**
**SCPI**
**B.P. 329**
**50, rue Jean-Pierre Timbaud**
**F-92402 Courbevoie Cédex (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

# Description

La présente invention concerne le domaine général de l'imagerie infrarouge et plus particulièrement celui de l'imagerie infrarouge réalisée à température ambiante.

Le principe de fonctionnement de l'imagerie infrarouge est le suivant. Un rayonnement infrarouge absorbé par une couche de matériau pyroélectrique génère une élévation de température ΔT dans la couche qui génère elle-même une quantité Q de charges électriques en surface, telle que :

$$Q = A. \, p_y. \, \Delta T$$

A représentant la surface de la couche recevant le rayonnement et $p_y$ étant son coefficient pyroélectrique.

En règle générale, la lecture du relief de charges électriques induit dans une couche pyroélectrique par un rayonnement incident est réalisée soit à l'aide d'un faisceau d'électrons dans un tube sous vide (décrit dans l'article "Le Pyricon : un tube de prise de vues pour le domaine infrarouge thermique" de M. BLAMOUTIER, P. CUNIBERTI, P. FELIX et S. VERON, paru dans la revue L'Onde Electrique, 1981, vol. 61, n° 10, p. 25 à 38), soit à l'aide d'une matrice plan de commutateurs associés à des lignes de transfert de charges (détecteurs deux dimensions tels que ceux décrits dans GB 2 200 246 et dans l'article "Ambient temperature solid state pyroelectric IR imaging arrays" de N. BUTLER, J. McCLELLAND et S. IWASA, paru dans SPIE, vol. 930, Infrared Detectors and Arrays, 1988, p. 151 à 163).

Cette technologie de détecteurs deux dimensions utilise des structures hydrides difficilement réalisables et fort coûteuses. La difficulté de réalisation et le prix élevé de ces détecteurs 2 dimensions sont dus à la complexité de ces structures. En effet, au lieu d'utiliser une couche pyroélectrique uniforme comme dans le tube Pyricon, les détecteurs 2 dimensions comportent autant d'éléments pyroélectriques qu'il y a d'éléments d'image ou pixels. Ces éléments pyroélectriques sont en outre placés sur des plots conducteurs de l'électricité mais isolants thermiques qui assurent la liaison électrique entre les éléments pyroélectriques et un substrat semiconducteur sous-jacent. Les faibles dimensions des éléments pyroélectriques (environ 200 μm x 200 μm) et des plots de liaison (environ 50 μm x 50 μm de section) rendent d'autant plus difficile la réalisation de ces structures lorsque l'on désire un nombre de pixels élevé.

On a aussi proposé [Patent Abstracts of Japan, vol 12 n° 228 (E-627) (3075) 28 juin 1988, JP-A-63868], de déposer une couche pyroélectrique ordinaire directement sur un substrat semiconducteur de lecture revêtu d'électrodes.

Afin de pallier les inconvénients des structures connues, la présente invention propose de remplacer les éléments pyroélectriques par une couche de matériau pyroélectrique répondant à certains critères permettant qu'on la dispose directement sur le substrat semiconducteur sous-jacent. L'invention présente l'avantage de simplifier la conception du détecteur en réalisant une structure monolithique tout en simplifiant la technologie de mise en oeuvre. En effet, un tel détecteur infrarouge peut être réalisé par des procédés courants en microélectronique.

L'invention a donc pour objet un détecteur infrarouge à base de matériau pyroélectrique, du type associé à un circuit de lecture élaboré sur un substrat semiconducteur (30), ledit substrat supportant également des plots conducteurs (32) destinés à transmettre les signaux électriques générés par le matériau pyroélectrique vers le circuit de lecture, chaque plot conducteur correspondant à un élément d'image ou pixel, le détecteur étant constitué d'une couche de matériau pyroélectrique (31) déposée sur le substrat semiconducteur côté plots conducteurs et comprenant une contre électrode (33) recouvrant ladite couche de matériau pyroélectrique du côté opposé aux plots conducteurs, caractérisé en ce que le matériau pyroélectrique possède une conductivité thermique K < 1 W/m.K et comprend du polymère.

L'invention sera mieux comprise et d'autres avantages apparaîtront à la lecture de la description qui va suivre, donnée à titre non limitatif, et grâce aux dessins annexés parmi lesquels :

- la figure 1 est une vue en coupe transversale d'un détecteur infrarouge selon l'art connu.
- la figure 2 est une vue schématique du détecteur infrarouge selon l'invention,
- la figure 3 est une vue en perspective d'un circuit de lecture associé au détecteur selon l'invention,
- la figure 4 représente un détecteur infrarouge selon l'invention associé à son circuit de lecture,
- les figures 5 à 7 représentent des circuits de lecture en cours de traitement avant de recevoir le détecteur infrarouge selon l'invention.

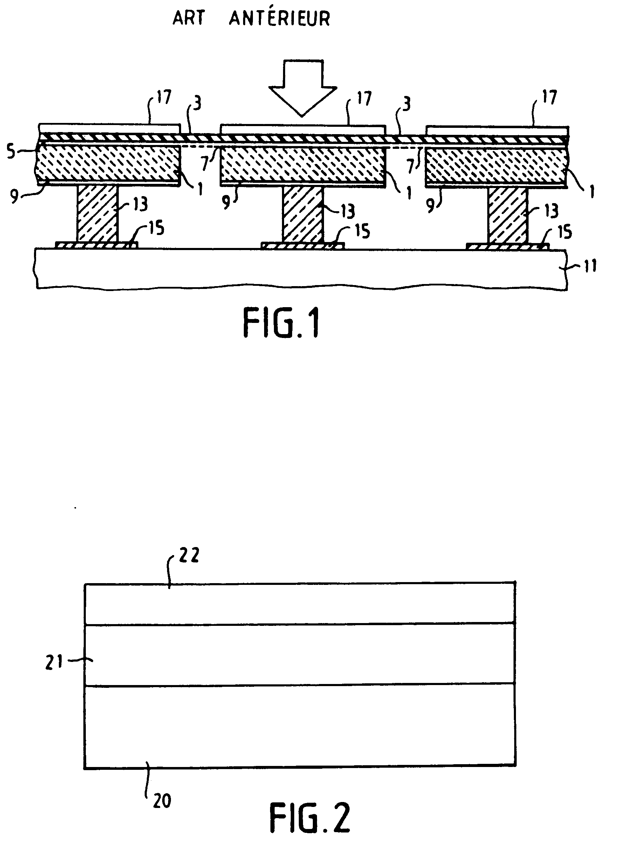

La figure 1 représente un détecteur infrarouge à base de matériau pyroélectrique selon la demande de brevet GB 2 200 246 citée plus haut. Ce détecteur comprend des éléments 1 en matériau pyroélectrique, à raison d'un élément par pixel, compris entre une électrode commune 5 et des électrodes élémentaires 9. Des plots conducteurs 13 relient électriquement les électrodes élémentaires 9 aux entrées 15 de circuits de traitement élaborés sur le substrat semiconducteur 11. Une couche 3, de faible conductivité thermique est placée au-dessus de l'électrode commune 5 et supporte, côté interne, des pistes conductrices 7 assurant la continuité électrique entre les différentes parties de l'électrode commune 5. Côté externe, la couche 3 supporte des parties 17 absorbant le rayonnement destiné aux éléments pyroélectriques 1 et représenté par la flèche.

Sur la figure 1 on n'a représenté que trois pixels mais le détecteur peut en comprendre beaucoup plus. Etant donné la très faible dimension de ces pixels et la façon dont les différentes parties du détecteur sont assemblées entre eux, on comprend la difficulté de réalisation d'une telle structure.

Le matériau pyroélectrique constituant les éléments 1 est choisi parmi un groupe de matériaux à fortes conductivités thermiques (K > 1 W/m.K) tels que :
- le tantalate de lithium $LiTaO_3$ pour lequel K = 4,2 W/m.K,
- le zirconate de plomb PZT pour lequel K = 1,7 W/m.K,
- le titanate de plomb $PbTiO_3$ pour lequel K = 3,2 W/m.K,
- le niobate de baryum et de strontium $SrBaNb_2O_6$ pour lequel K = 3,8 W/m.K.

Dans de tels matériaux, l'énergie thermique absorbée en surface se propage très vite dans l'épaisseur. Si les éléments pyroélectriques 1 étaient disposés directement sur le substrat 11, l'énergie thermique se dissiperait rapidement par effet de conduction dans le substrat. Si ce substrat est bon conducteur thermique comme le silicium (pour lequel K = 140 W/m.K) l'effet est encore amplifié. De ce fait, il est nécessaire d'isoler thermiquement les éléments pyroélectriques du substrat qui se comporte comme un puits thermique. Cela implique l'utilisation de la technologie hybride à base de plots conducteurs de l'électricité mais isolants thermiques. A ce titre, l'article de N. BUTLER et al (cité précédemment) montre que l'introduction de structures isolantes entre pixels et sous les pixels est nécessaire en pratique pour les détecteurs pyroélectriques utilisant les matériaux pyroélectriques classiques, dès lors qu'une résolution et une sensibilité suffisantes sont désirées.

Selon l'invention, et pour pallier les inconvénients de l'art antérieur, on dépose sur le substrat semiconducteur, sur lequel ont été élaborés les circuits de traitement et contenant la matrice 2 dimensions de commutateurs de lecture et les lignes de transfert de charges, une couche de matériau pyroélectrique. Cette couche peut être déposée par centrifugation pour les polymères et par sérigraphie pour les matériaux composites.

Selon l'invention, on choisit des matériaux pyroélectriques possédant de faibles conductivités thermiques (K < 1 W/m.K). On peut utiliser des polymères (pour lesquels généralement K est inférieur à 0,2 W/m.K) tels que :
- le polyfluorure de vinylidène (PVDF),
- le polyfluorure de vinylidène - trifluoroéthylène (PVDF-TrFE),
- le polycyanure de vinylidène - vinylacétate (PVDCN-VAc),
- le polycyanure de vinylidène - fluorure de vinylidène (PVDCN - VDF).

On peut également utiliser des matériaux composites (pour lesquels K < 1 W/m.K) tels que des composés de charges minérales de grande conductivité thermique mélangées dans une matrice polymère de faible conductivité thermique. Par exemple, 60 % en poids de PZT dans du polyimide donne un coefficient K d'environ 0,9 W/m.K.

Après avoir déposé la couche de matériau pyroélectrique, on métallise la face supérieure de cette couche. Ensuite, pour polariser cette couche, on appliquera une tension permettant d'obtenir environ 1 MV/cm de champ électrique, soit 1000 volts pour 10 μm d'épaisseur de couche de matériau pyroélectrique.

Une couche de matériau absorbant infrarouge est ensuite déposée sur la couche pyroélectrique métallisée. La structure obtenue a alors la forme représentée schématiquement à la figure 2 : une couche 21 de matériau pyroélectrique reposant sur le substrat semiconducteur 20 et recouverte d'une couche 22 d'absorbant infrarouge.

La couche d'absorbant infrarouge peut être réalisée soit par évaporation de noirs métalliques (or, aluminium ou argent) ou de métaux absorbants tels qu'un alliage nickel-chrome, soit par dépôt en centrifugeant une solution contenant du polymère absorbant entre 3 et 14 μm.

Par rapport à l'art antérieur, la structure selon l'invention est beaucoup plus simple car elle ne comporte pas de plots isolants thermiques et conducteurs de l'électricité, lesquels servaient à isoler thermiquement la couche détectrice du substrat et à collecter les charges électriques correspondant à l'information thermique reçue.

Le fait d'utiliser des matériaux à conductivité thermique K < 1 W/m.K permet de s'affranchir de ces plots et de déposer le matériau pyroélectrique directement sur le circuit de lecture. D'autre part, il est possible d'utiliser des épaisseurs de matériau pyroélectrique supérieures à 10 μm sans détériorer la résolution spatiale et de ce fait, il n'est pas nécessaire de réticuler la couche détectrice en pixels isolés comme il est habituellement fait dans l'art antérieur.

Deux exemples de réalisation vont maintenant être décrits. Le premier exemple concerne le cas découlant directement de l'invention et où le polymère pyroélectrique est déposé directement sur le circuit de lecture. Le deuxième exemple concerne le cas où, dans des cas limites, on désire quand même déposer une couche d'isolant thermique entre le polymère pyroélectrique et le circuit de lecture.

Premier exemple de réalisation :

Le circuit de lecture (CCD, transistor à effet de champ, etc.) a été préalablement fabriqué sur un substrat de silicium, suivant les techniques habituelles connues de l'homme de l'art. L'épaisseur de ce substrat est par exemple comprise entre 0,5 et 1 mm.

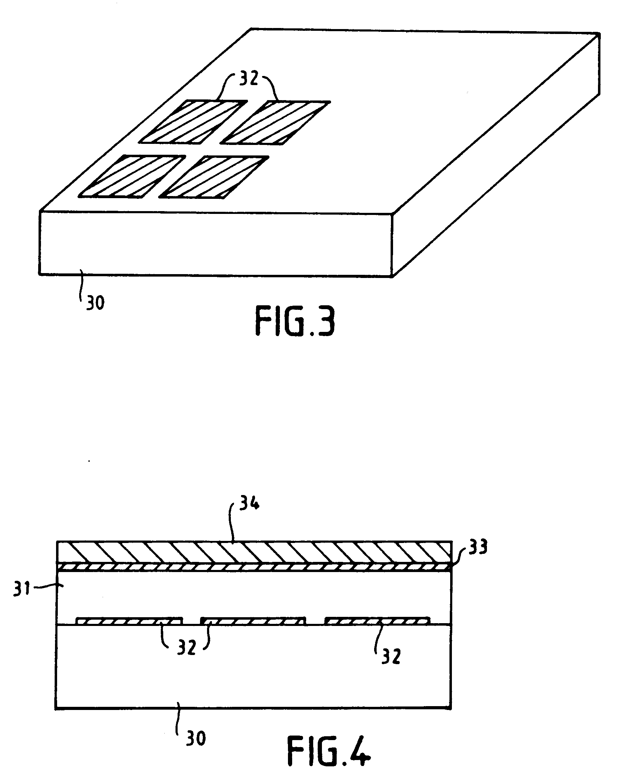

La figure 3 représente, vu en perspective, un tel substrat référencé 30 et comportant sur sa partie supérieure un jeu d'électrodes en forme de plots conducteurs 32. Ces plots sont répartis régulièrement à la surface du substrat 30 et correspondent à autant de pixels qu'il est désiré. Ils peuvent être répartis de façon à former un arrangement matriciel. Les plots 32 peuvent avoir 250 μ de côté et peuvent être séparés de 10 μ. Il est possible de les obtenir par une évaporation de métal de 1000 angströms d'épaisseur.

Une couche 31 de matériau pyroélectrique répondant aux conditions de l'invention est ensuite déposée sur la face supérieure du substrat 30 (voir la figure 4). Le dépôt peut être réalisé par centrifugation d'une solution de polymère dans un solvant par exemple, un copolymère PVDF-TrFE 75/25 (75 % en moles de PVDF pour 25 % en moles de TrFE) dans le diméthylformamide (DMF). Cette méthode de dépôt est habituellement désignée sous le nom de "méthode de la tournette". Plusieurs couches de polymère pyroélectrique peuvent être déposées pour obtenir une épaisseur comprise entre 5 et 60 μm, par exemple 30 μm.

Sur la couche 31, on dépose ensuite une électrode continue 33 pour constituer une contre-électrode, par exemple sous forme d'une couche d'aluminium de 1000 angströms d'épaisseur, par évaporation sous vide.

On peut alors polariser la couche de polymère 31. La polarisation peut se faire en mettant toutes les électrodes du circuit de lecture à la masse, et plus particulièrement tous les plots conducteurs du circuit de lecture, et en appliquant une tension + V sur l'électrode continue 33 (par exemple, V = 3000 volts si l'épaisseur de polymère est égale à 30 μm).

Une couche d'absorbant infrarouge 34 est ensuite déposée, par exemple du noir d'aluminium par évaporation d'aluminium sous atmosphère d'azote selon une technique connue. Le détecteur est alors prêt à fonctionner.

L'absorbant infrarouge peut être déposé avant l'opération de polarisation. La polarisation peut aussi être effectuée avant le dépôt de l'électrode continue 33. La polarisation se fait alors par effet Corona.

Deuxième exemple de réalisation :

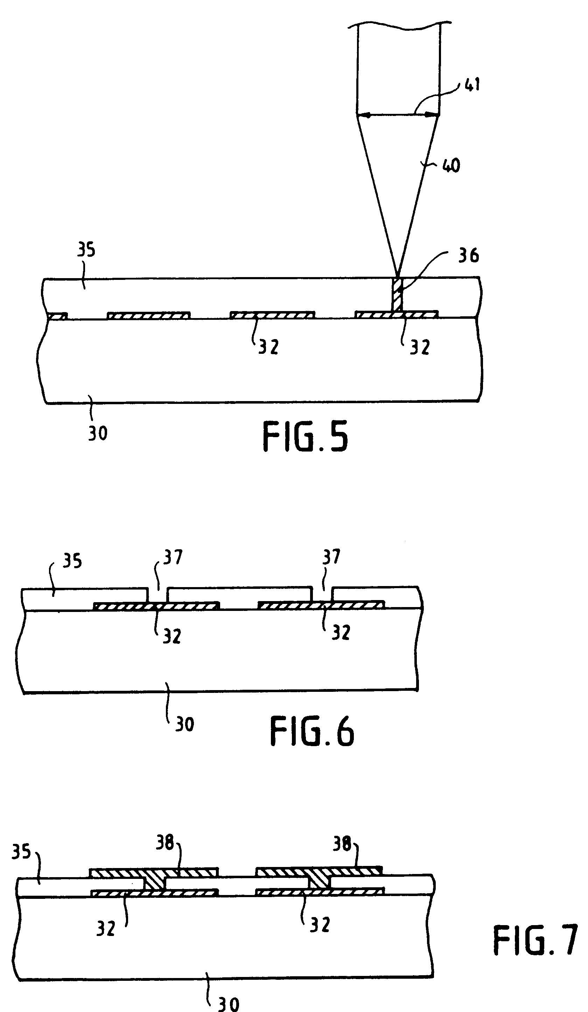

Le substrat utilisé est celui représenté à la figure 3. On dépose sur le substrat 30 recouvert de plots conducteurs 32, une couche 35 d'isolant thermique (voir la figure 5). Cette couche d'isolant thermique peut être un polymère déposé à la tournette (par exemple 10 μm de polyimide). Dans ce cas un recuit à 300 - 400°C pendant 1 heure est alors nécessaire pour obtenir l'imidisation complète du polyimide.

Il faut ensuite reprendre les contacts électriques sur les plots du circuit de lecture. Plusieurs méthodes sont possibles.

On peut, à l'aide d'un faisceau laser de longueur d'onde inférieure à 500 nm, pyrolyser le polyimide sur une surface d'environ 10 μm$^2$ et au-dessus des plots 32, comme le montre la figure 5 où le faisceau laser, focalisé par la lentille 41, est représenté sous la référence 40. On crée ainsi de petits fils conducteurs ($\sigma$ = 1 S.cm$^{-1}$) à travers le polyimide.

On peut aussi, comme le montrent les figures 6 et 7, faire une ablation de matière par laser pour réaliser de petits trous 37, par exemple grâce à un laser Eximère délivrant un faisceau de longueur d'onde inférieure à 300 nm. Il suffit ensuite de déposer localement des métallisations 38 matérialisant les pixels pour prendre contact avec les plots conducteurs 32 et disposer d'une réplique du jeu d'électrodes qui sont présentes sur le circuit de lecture. D'autres méthodes connues peuvent encore être utilisées pour graver le polyimide.

Le substrat est alors prêt à recevoir la couche de matériau pyroélectrique selon le procédé développé dans la description du premier exemple de réalisation.

Résultats obtenus:

Un polymère pyroélectrique formé de PVDF-TrFE (75/25) possède un coefficient pyroélectrique $p_y$ de $5.10^{-9}$ C/cm$^2$ .K, un coefficient K de 0,0013 W/cm.K et une constante diélectrique relative $\varepsilon$ = 7. Pour une structure selon l'invention comportant une surface de pixel de 250 μ de côté et pour une épaisseur de couche pyroélectrique de 30 μ, le coefficient NETD (Noise Equivalent Temperature Difference) est :

- pour le premier exemple de réalisation : NETD = 0,5K pour une cadence de détection de 50 Hz et pour une ouverture numérique de l'objectif de visée N = 1,
- pour le deuxième exemple de réalisation : NETD = 0,3K dans les mêmes hypothèses que précédemment.

**Revendications**

1. Détecteur infrarouge à base de matériau pyroélectrique, du type associé à un circuit de lecture élaboré sur un substrat semiconducteur (30), ledit substrat supportant également des plots conducteurs (32) destinés à transmettre les signaux électriques générés par le matériau pyroélectrique vers le circuit de lecture, chaque plot conducteur correspondant à un élément d'image ou pixel, le détecteur étant constitué d'une couche de matériau pyroélectrique (31) déposée sur le substrat semiconducteur côté plots conducteurs et comprenant une contre électrode (33) recouvrant ladite couche de matériau pyroélectrique du côté opposé aux plots conducteurs, caractérisé en ce que le matériau pyroélectrique possède une conductivité thermique K < 1 W/m.K et comprend du polymère.

2. Détecteur infrarouge selon la revendication 1, caractérisé en ce que les plots conducteurs (32) sont disposés de façon à former un arrangement matriciel.

3. Détecteur infrarouge selon l'une des revendications 1 ou 2, caractérisé en ce que ledit polymère est du polyfluorure de vinylidène, du polyfluorure de vinylidène-trifluoroéthylène, du polycyanure de vinylidène-vinylacétate ou du polycyanure de vinylidène-fluorure de vinylidène.

4. Détecteur infrarouge selon l'une des revendications 1 ou 2, caractérisé en ce que le matériau pyroélectrique est un matériau composite constitué de charges minérales pyroélectriques de conductivité thermique élevée mélangées dans une matrice polymère de faible conductivité thermique.

5. Détecteur infrarouge selon la revendication 4, caractérisé en ce que le matériau composite est formé de 60 % en poids de zirconate de plomb mélangé à du polyimide.

6. Détecteur infrarouge selon l'une quelconque des revendications 1 à 5, caractérisé en ce qu'à la couche de matériau pyroélectrique (31) est associée une couche d'isolant thermique (35) disposée entre le substrat semiconducteur (30) et la couche de matériau pyroélectrique, des moyens de conduction électrique (38) étant disposés entre les plots conducteurs et la face de la couche de matériau pyroélectrique adjacente à la couche d'isolant thermique et au travers de cette couche d'isolant thermique.

7. Détecteur infrarouge selon l'une quelconque des revendications précédentes, caractérisé en ce qu'une couche d'absorbant infrarouge (34) est déposée sur la contre-électrode (33).

**Patentansprüche**

1. Infrarotdetektor auf der Basis eines pyroelektrischen Materials in Verbindung mit einer auf ei-nem Halbleitersubstrat (30) ausgebildeten Lese-schaltung, wobei das Substrat weiter leitende Beläge (32) aufweist, die die elektrischen Signale, die vom pyroelektrischen Material erzeugt werden, zur Leseschaltung übertragen, wobei jeder leitende Belag einem Bildelement oder Pixel entspricht und der Detektor aus einer Schicht von pyroelektrischem Material (31) besteht, die auf das Halbleitersubstrat auf der Seite der leitenden Beläge aufgebracht ist, und wobei der Detektor eine Gegenelektrode (33) aufweist, die die Schicht aus pyroelektrischem Material auf der den leitenden Belägen abgewandten Seite bedeckt, dadurch gekennzeichnet, daß das pyroelektrische Material eine Wärmeleitfähigkeit K unter 1 W/m·K besitzt und ein Polymer enthält.

2. Infrarotdetektor nach Anspruch 1, dadurch gekennzeichnet, daß die leitenden Beläge (32) in Form einer Matrix angeordnet sind.

3. Infrarotdetektor nach einem der Ansprüche 1 oder 2, dadurch gekennzeichnet, daß das Poly-mer ein Polyvinylidenfluorid, ein Polyvinylidenflu-orid-Trifluoräthylenfluorid, ein Polyvinyliden-Vi-nylacetatcyanid oder ein Polyvinylidencyanid-Vi-nylidenfluorid ist.

4. Infrarotdetektor nach einem der Ansprüche 1 oder 2, dadurch gekennzeichnet, daß das pyroelektrische Material ein Verbundmaterial ist, das aus der Mischung von pyroelektrischen Mineralstoffen mit hoher Wärmeleitfähigkeit und einer Polymermatrix mit niedriger Wärmeleitfähigkeit besteht.

5. Infrarotdetektor nach Anspruch 4, dadurch gekennzeichnet, daß das Verbundmaterial aus einer Mischung von 60 Gew.% Bleizirkonat und im übrigen Polyimid besteht.

6. Infrarotdetektor nach einem beliebigen der Ansprüche 1 bis 5, dadurch gekennzeichnet, daß der Schicht aus pyroelektrischem Material (31) eine Wärmeisolierschicht (35) zugeordnet ist, die zwischen dem Halbleitersubstrat (30) und der Schicht aus pyroelektrischem Material liegt, wobei elektrische Leitmittel (38) zwischen den leitenden Belägen und der Seite der Schicht aus pyroelektrischem Material angeordnet sind, die an der Wärmeisolierschicht anliegt, wobei diese Mittel durch diese Wärmeisolierschicht hindurch verlaufen.

7. Infrarotdetektor nach einem beliebigen der vor-hergehenden Ansprüche, dadurch gekennzeich-net, daß eine Schicht aus einem die Infrarotstrahlung absorbierenden Material (34) auf die Gegenelektrode (33) aufgebracht ist.

## Claims

1.  Infrared detector based on pyroelectric material, of the type associated with a reading circuit prepared on a semiconductor substrate (30), the said substrate also supporting conductive blocks (32) designed to transmit the electrical signals generated by the pyroelectric material towards the reading circuit, each conductive block corresponding to a picture element or pixel, the detector being formed by a layer of pyroelectric material (31) deposited on that side of the semiconductor substrate having the conductive blocks and comprising a counter-electrode (33) covering the said layer of pyroelectric material on the side opposite to the conductive blocks, characterized in that the pyroelectric material has a thermal conductivity $K < 1$ W/m.K and comprises polymer.

2.  Infrared detector according to Claim 1, characterized in that the conductive blocks (32) are arranged so as to form a matrix arrangement.

3.  Infrared detector according to either of Claims 1 or 2, characterized in that the said polymer is polyvinylidene fluoride, polyvinylidene fluoride-trifluoroethylene, polyvinylidene cyanide vinyl acetate, or polyvinylidene cyanide-vinylidene fluoride.

4.  Infrared detector according to either of Claims 1 or 2, characterized in that the pyroelectric material is a composite material consisting of pyroelectric mineral fillers of high thermal conductivity mixed in a polymer matrix of low thermal conductivity.

5.  Infrared detector according to Claim 4, characterized in that the composite material consists of 60% by weight of lead zirconate mixed with polyimide.

6.  Infrared detector according to any one of Claims 1 to 5, characterized in that the layer of pyroelectric material (31) is associated with a layer of thermal insulant (35) arranged between the semiconductor substrate (30) and the layer of pyroelectric material, means of electrical conduction (38) being arranged between the conductive blocks and the face of the layer of pyroelectric material adjacent to the layer of thermal insulant and across this layer of thermal insulant.

7.  Infrared detector according to any one of the preceding claims, characterized in that a layer of infrared absorbent (34) is deposited on the counter-electrode (33).

ART ANTÉRIEUR

## FIG.1

## FIG.2

FIG.3

FIG.4

FIG.5

FIG.6

FIG.7